# EUROPEAN PATENT APPLICATION

(11) **EP 4 024 379 A1**
(43) Date of publication of application: **06.07.2022**
(21) Application number: 20883263.4
(22) Date of filing: 29.09.2020
(51) Int. Cl.: G09G 3/20

(54) **DISPLAY APPARATUS AND ELECTRONIC DEVICE**

(30) Priority: 31.10.2019 CN 201911049785
(71) Applicant: GUANGDONG OPPO MOBILE TELECOMMUNICATIONS CORP., LTD., Dongguan, Guangdong 523860 (CN)
(72) Inventor: LI, Liang, Dongguan, Guangdong 523860 (CN)
(74) Representative: Thorniley, Peter
(86) International application number: PCT/CN2020/118834
(87) International publication number: WO 2021/082854

(57) **Abstract**

Embodiments of the present application provide an electronic device and a display apparatus. The display apparatus comprises a first display area, and further comprises a plurality of first pixels and a plurality of first driving units, the plurality of first pixels being provided in the first display area, the plurality of first driving units being configured to drive the plurality of first pixels, each of the first driving units comprising at least two thin film transistors, and at least one thin film transistor in each first driving unit being disposed outside the first display area. The embodiments of the present application can increase the display-to-body ratio of the electronic device.

## Description

This application claims priority to Chinese patent application No. 201911049785.0, entitled "DISPLAY APPARATUS AND ELECTRONIC DEVICE", filed on October 31, 2019, the content of which is incorporated herein by reference in its entirety.

### TECHNICAL FIELD

The present disclosure relates to the electronic technology field, and more particularly to a display apparatus and an electronic device.

### BACKGROUND

With the development of communication technology, electronic devices, such as smart phones, are becoming more and more popular. During the use of an electronic device, the electronic device can use its display screen to display an image. Drive units, such as TFTs and other devices inside the display screen, block light. This results in that a light transmittance of the display screen is low.

### SUMMARY OF DISCLOSURE

Embodiments of the present disclosure provide a display apparatus and an electronic device capable of increasing a light transmittance of the display apparatus.

An embodiment of the present disclosure provides a display apparatus including a first display area. The display apparatus further includes: a plurality of first pixels, wherein the first pixels are disposed in the first display area; and a plurality of first drive units, wherein the first drive units are used for driving the first pixels, each of the first drive units includes at least two thin film transistors, and at least one of the at least two thin film transistors of each of the first drive units is disposed outside the first display area.

An embodiment of the present disclosure provides an electronic device including a display apparatus and a sensor. The display apparatus includes a first display area. The display apparatus further includes: a plurality of first pixels, wherein the first pixels are disposed in the first display area; and a plurality of first drive units, wherein the first drive units are used for driving the first pixels, each of the first drive units includes at least two thin film transistors, and at least one of the at least two thin film transistors of each of the first drive units is disposed outside the first display area.

### BRIEF DESCRIPTION OF DRAWINGS

The following briefly introduces the accompanying drawings required for describing the implementations.
FIG. 1 illustrates a structural schematic diagram of an electronic device provided by an embodiment of the present disclosure.
FIG. 2 illustrates a structural schematic diagram of a display apparatus in the electronic device in FIG. 1.
FIG. 3 illustrates a cross-sectional view of the display apparatus along a P2-P2 direction in FIG. 2.
FIG. 4 illustrates a first partial schematic view of the display apparatus in FIG. 2.
FIG. 5 illustrates a second partial schematic view of the display apparatus in FIG. 2.
FIG. 6 illustrates a first arrangement schematic diagram of a first display unit in the first display area of the display apparatus in FIG. 2.
FIG. 7 illustrates a second arrangement schematic diagram of a first display unit in the first display area of the display apparatus in FIG. 2.
FIG. 8 illustrates a third arrangement schematic diagram of a first display unit in the first display area of the display apparatus in FIG. 2.
FIG. 9 illustrates a third arrangement schematic diagram of a first display unit in the first display area of the display apparatus in FIG. 2.
FIG. 10 illustrates another structural schematic diagram of a display apparatus provided by an embodiment of the present disclosure.
FIG. 11 illustrates a cross-sectional view of the display apparatus along a direction P4-P4 in FIG. 10.
FIG. 12 illustrates a first partial schematic diagram of the display apparatus in FIG. 10.
FIG. 13 illustrates a second partial schematic diagram of the display apparatus in FIG. 10.
FIG. 14 illustrates a third partial schematic diagram of the display device in FIG. 10.
FIG. 15 illustrates a third partial schematic view of the display apparatus in FIG. 2.
FIG. 16 illustrates a first circuit schematic diagram of one first drive unit in the display apparatus provided by an embodiment of the present disclosure.
FIG. 17 illustrates a second circuit schematic diagram of one first drive unit in the display device provided by an embodiment of the present disclosure.
FIG. 18 illustrates a third circuit schematic diagram of one first drive unit in the display device provided by an embodiment of the present disclosure.
FIG. 19 illustrates a structural schematic structural diagram of the display apparatus and the camera in the electronic device provided by an embodiment of the present disclosure.
FIG. 20 illustrates another structural schematic diagram of the display device and the camera in the electronic device according to an embodiment of the present disclosure.

### DETAILED DESCRIPTION OF EMBODIMENTS

Embodiments of the present disclosure provide an electronic device and a display apparatus thereof. The electronic device can include the display apparatus and a camera. The camera can be installed below the display apparatus. That is, the camera can capture an image through the display apparatus. It can be understood that a light transmittance of a conventional display apparatus is low, and thus a camera has a poor effect of capturing an image through the display apparatus. To this end, the embodiments of the present disclosure can divide the display apparatus into a plurality of regions. For example, a light transmittance of a portion of the display apparatus corresponding to the camera is set to be greater than a light transmittance of each of other positions of the display device. This can improve the effect of capturing an image through the camera. The technical solutions in the embodiments of the present disclosure will be clearly and completely described below with reference to the accompanying drawings in the embodiments of the present disclosure.

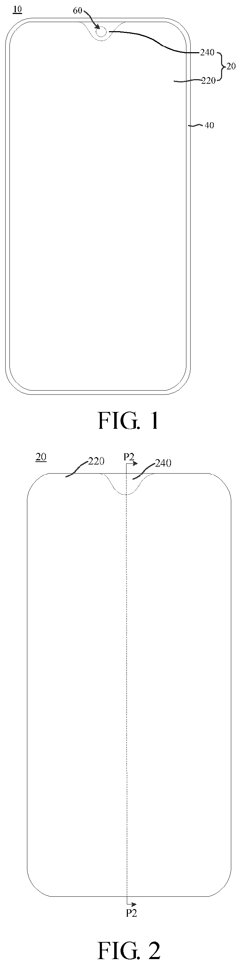

Please refer to FIG. 1. FIG. 1 illustrates a schematic diagram of a first structure of an electronic device provided by an embodiment of the present disclosure. The electronic device 10 can be a computing device (such as a laptop computer), a computer monitor containing an embedded computer, a tablet computer, a cellular telephone, a media player, or other handheld or portable electronic device, a smaller device (such as a wristwatch device, a pendant device, a headphone or earpiece device, a device embedded in eyeglasses or other equipment worn on a user's head, or other wearable or miniature device), a television, a computer display that does not contain an embedded computer, a gaming device, a navigation device, an embedded system (such as a system in which electronic equipment with a display is mounted in a kiosk or automobile), equipment that implements the functionality of two or more of these devices, or other electronic equipment. In the illustrative configuration of FIG. 1, the electronic device 10 is a portable device, such as a cellular telephone, a media player, a tablet computer, or other portable computing device. Other configurations can be used for the electronic device 10 if desired. The example of FIG. 1 is merely illustrative.

Please continue to refer to FIG. 1. The electronic device 10 includes a display apparatus 20. The display device 20 can display an image. The display apparatus 20 can be an organic light-emitting diode (OLED) display apparatus 20. A display surface of the display apparatus 20 can have a larger display area and a narrower non-display area, or the display apparatus 20 has a narrower black border. Certainly, the whole of the display surface of the display apparatus 20 can also be a display area without disposing a non-display area. That is, the display apparatus 20 can be a full screen. The display apparatus 20 can be protected by a display apparatus cover layer, such as a transparent glass layer, a light transmissive plastic material, a sapphire, or other transparent dielectric layer.

The display apparatus 20 can be in a regular shape, such as a rectangle, a rectangle with rounded corners, or a circle. Certainly, in some other possible embodiments, the display apparatus 20 can also be in an irregular shape. The shape is not limited in the embodiments of the present disclosure.

Please refer to FIG. 2. FIG. 2 illustrates a structural schematic diagram of the display apparatus in the electronic device in FIG. 1. The display apparatus 20 can include a first display area 240 and a second display area 220. Both of the first display area 240 and the second display area 220 can display an image. The first display area 240 and the second display area 220 can display the same image or display different images.

The first display area 240 and the second display area 220 can be adjacent to each other. For example, a periphery of the first display area 240 is surrounded by the second display area 220. For another example, a portion of the first display area 240 is surrounded by the second display area 220. That is, the first display area 240 is located at a position of an end surface or a position of connecting an end surface of the display apparatus 20. It can be understood that the position of connecting the end surface of the display apparatus 20 is a position where two end surfaces of the display apparatus 20 are connected to each other and can include a portion of the two end surfaces which are connected to each other. It should be noted that there can be one or more first display areas 240. When there are multiple first display areas 240, the multiple first display areas 240 can be located at the same end surface of the display apparatus 20, can also be located at multiple end surfaces of the display apparatus 20, or can also be located at multiple positions of connecting end surfaces of the display apparatus 20. Alternatively, a portion of the multiple first display areas 240 is located at the positions of connecting the end surfaces of the display apparatus 20, and a portion is located at the positions of the end surfaces of the display apparatus 20.

In the present embodiment of the present disclosure, a display area of the second display area 220 can be set to be larger than a display area of the first display area 240. The second display area 220 can be used as a main display area of the display apparatus 20, and the first display area 240 can be used as an auxiliary display area of the display apparatus 20 or a function display area. For example, a light transmittance of the first display area 240 can be set to be greater than a light transmittance of the second display area 220. As such, in a non-display state of the first display area 240, the light transmittance of the first display area 240 can be increased significantly, and the sensor (such as the camera 60) of the electronic device 100 can be disposed at the position of the first display area 240, so as to improve quality of implementing signal transmission by the sensor (such as the camera 60) through the first display area 240.

It should be noted that in some embodiments, the display area of the first display area 240 and the display area of the second display area 220 can be set to be the same, or the display area of the first display area 240 can be set to be larger than the display area of the second display area 220.

In the present embodiment of the present disclosure, a device (such as the camera 60, a sensor or the like) can be disposed at the position of the first display area 240 (such as below the first display area 240). When the first display area 240 is in a non-display state, the device (such as the camera 60, the sensor or the like) can perform signal transmission in the first display area 240, for example, capturing an image. Furthermore, the first display area 240 can also display an image according to requirements, so as to realize integrity of the display apparatus 20 and integrity of the display areas. Not only a hidden design of the device (such as the camera 60, the sensor or the like) can be achieved, but also a screen ratio of the electronic device 10 can be increased.

It should be noted that the position of the sensor (such as the camera 60) of the electronic device 10 is not limited to be below the first display area 240, and it can also be disposed far away from the first display area 240. A light guide column can be disposed between the sensor (such as the camera 60) and the first display area 240 to realize the signal transmission. The light guide column can transmit a light signal emitted by the light sensor (such as the camera 60) to the first display area 240, and transmit the light to the outside of the electronic device 10 through the first display area 240. The light guide column can also transmit an external light signal to the light sensor (such as the camera 60) through the first display area 240. The light guide column can be a cylindrical structure or a multi-segment structure. When the light guide column has a multi-segment structure, it can have at least one light guide surface to realize reflection of a light signal.

In order to set the light transmittance of the first display area 240 to be greater than the light transmittance of the second display area 220, drive units (such as thin film transistors (TFTs)) which drive the first display area 240 in the display apparatus can be disposed outside the first display area 240 in the embodiment of the present disclosure. For example, the driver units are disposed in a drive layer structure which drives the second display area 220 in the display apparatus 20. For another example, the driver units are disposed in a side or periphery of the display apparatus 20. For yet another example, the drive units are disposed in the non-display area of the display apparatus 20. For yet another example, a double-layer drive layer structure is provided in the display apparatus 20, and the drive units (such as the thin film transistors) which drive the first display area 240 are disposed in a drive layer structure corresponding to the second display area 220 through vias.

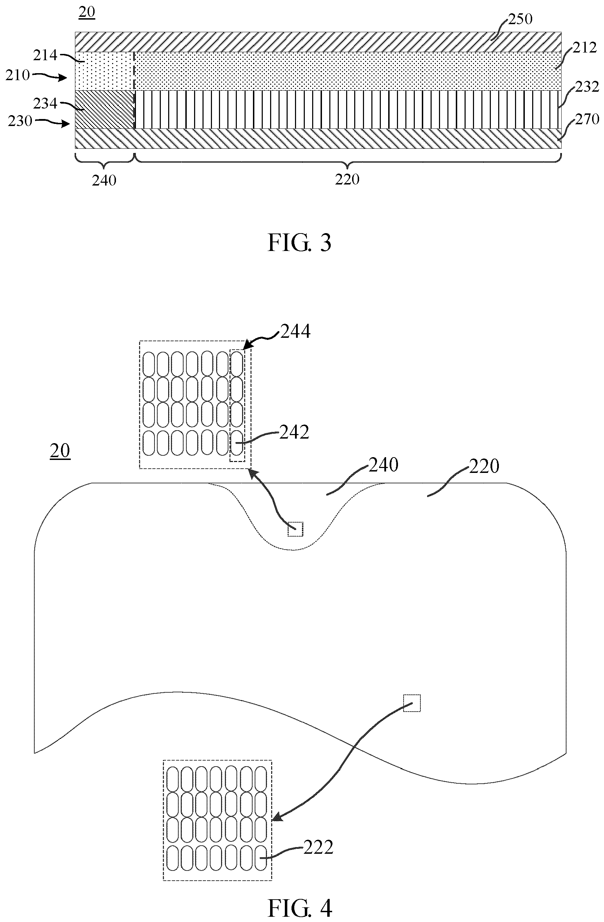

Please refer to FIG. 3. FIG. 3 illustrates a cross-sectional view of the display apparatus along a P2-P2 direction in FIG. 2. The display apparatus 20 can include an upper substrate 250, a display layer 210, a drive layer 230, and a lower substrate 270 which are stacked sequentially. The display apparatus 20 can display an image by driving the display layer 210 through the drive layer 230. Both of the upper substrate 250 and the lower substrate 270 can be made of a transparent material (such as transparent glasses). The lower substrate 270 can be defined as a first substrate, and the upper substrate 250 can be defined as a second substrate.

The display layer 210 can include a plurality of pixels. The display layer 210 includes a second display part 212 located in the second display area 220 and a first display part 214 located in the first display area 240. That is, the display layer 210 can include a plurality of second pixels in the second display area 220 and a plurality of first pixels in the first display area 240. Both of the plurality of second pixels and the plurality of first pixels can be arranged in an array. An arrangement of the first pixels 242 in the first display area 240 can be one of a standard RGB arrangement, a Pentile arrangement, or a Delta arrangement, and an arrangement in the second pixels 222 of the second display area 220 can be one of a standard RGB arrangement, a Pentile arrangement, or a Delta arrangements. It should be noted that the first pixels 242 in the first display area 240 can also adopt other arrangements, and the second pixels 222 in the second display area 220 can also adopt other arrangements.

It should be understood that "a plurality of' mentioned herein means two or more.

In order to further increase the light transmittance of the first display area 240, a light transmitting material can be used for the first pixels in the first display area 240 in the embodiment of the present disclosure. Certainly, in some other embodiments, the arrangement of the first pixels can be sparser than the arrangement of the second pixels. That is, a distribution density of the first pixels can be smaller than a distribution density of the second pixels.

The drive layer 230 can include a plurality of drive units, and each of the drive unit can drive a pixel. The drive layer 230 includes a plurality of first drive units for driving the first display area 240 and a plurality of second drive units for driving the second display area 220. Each of the first drive units can be electrically connected to one of the first pixels and can drive the one of the first pixels. Each of the second drive unit is electrically connected to one of the second pixel and can drive the one of the second pixels. The drive layer 230 can include a second drive part 232 located in the second display area 220 and a first drive part 234 located in the first display area 240. The plurality of second drive units can be disposed in the second drive part 232, and the plurality of first drive unit can be disposed in the first drive part 234.

Each of the drive units can adopt one of drive circuits (such as 2T1C, 5T1C, or 7T1C). For example, each of the first drive unit can adopt one of 2T1C, 5T1C, and 7T1C, and the second drive unit can adopt one of 2T1C, 5T1C, and 7T1C. T represents "thin film transistor", and C represents "capacitor". In order to increase the light transmittance of the first display area 240, the first drive units disposed in the first display area 240 can be drive circuits simpler than drive circuits of the main drive unit of the second display area 220. For example, a number of thin film transistors included in each of the first drive units is less than a number of thin film transistors includes in each of the second drive units. For example, each of the first drive units can adopt one of 2T1C and 5T1C, and each of the second drive units can adopt 7T1C. A number of opaque thin film transistors in each of the first drive units is less. When an opaque portion of the first display area 240 is smaller, the light transmittance of the first display area 240 can be increased.

Please refer to FIG. 4. FIG. 4 illustrates a first partial schematic view of the display apparatus in FIG. 2. Physical structures of the second pixels 242 of the second display area 220 and the first pixels 222 of the first display area 240 can be the same. In other words, the pixels in the second display area 220 and the first display area 240 can have the same physical structure and can be formed in the same process. For example, a size of each of the second pixels 222 is the same as a size of each of the first pixels 242, and the arrangement of the second pixels 222 is the same as the arrangement of the first pixels 242. The second pixels 222 and the first pixels 242 can be formed in the same process. It should be noted that the physical structures of the second pixels 222 in the second display area 220 and the first pixels 242 in the first display area 240 can also be different. For example, the size of each of the second pixels is larger than the size of each of the first pixels. For another example, an arrangement density of the second pixels is larger than an arrangement density of the first pixels. It should be noted that FIG. 4 only illustrates some pixels of the display apparatus 20, and an area formed by the arrangement of the first pixels 242 in FIG. 4 is approximately the same as an area formed by the arrangement of the second pixels 222.

The first display area 240 can have a plurality of first pixel sets 244, and each of the first pixel sets 244 can include a plurality of first pixels 242 connected in parallel. One of the first pixel sets 244 can include at least two first pixels 242, which can include at least two first pixels 242 with the same color (such as red pixels). One of the first pixel sets 244 can also include at least two first pixels 242 with different colors (such as a red pixel and a green pixel). A plurality of first pixels 242 in one of the first pixel sets 244 can be connected together by a plurality of signal lines, and the signal lines can be made of a light transmitting material.

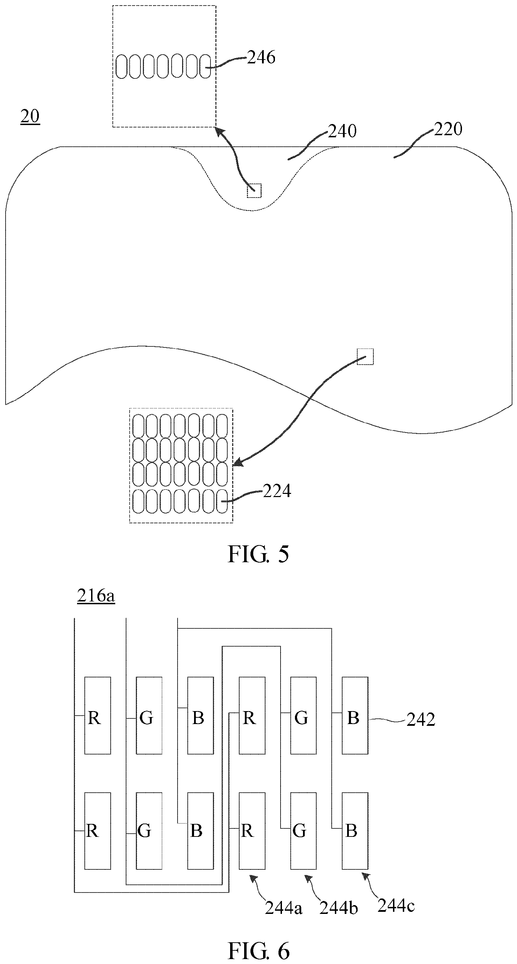

Please refer to FIG. 5. FIG. 5 illustrates a second partial schematic view of the display apparatus in FIG. 2. FIG. 5 shows a plurality of second drive units 224 in the second display area 220 and a plurality of first drive units 246 in the first display area 240. One of the second drive units 224 can be electrically connected to one of the second pixels 222, and the one of the second drive unit 224 can drive the one of the second pixels 222. Each of the first pixel sets 244 can be electrically connected to one of the first drive units 246. One of the first drive units 246 can drive one of the first pixel sets 244. That is, the one of the first drive units 246 can drive all first pixels in the one of the first pixel sets 244. Compared with one drive unit driving one pixel, a number of the first drive units can be reduced in the embodiment of the present disclosure. In the embodiment of the present disclosure, the first drive units 246 can be disposed in the first display area 240 (such as in the first drive part 234). Since the plurality of first pixels 242 in the first display area 240 can be driven by using fewer first drive units 246, the light transmittance of the first display area 240 can be increased. It should be noted that FIG. 5 only illustrates a portion of the second drive unit 224 and a portion of the first drive unit 246 of the display apparatus 20, and an area formed by the arrangement of the first drive unit 246 in FIG. 5 is approximately the same as an area formed by the drive units 224.

In the embodiment of the present disclosure, one of the first pixel sets 244 can be used as a first display unit of the first display area 240. That is, the first display unit is a smallest unit for displaying an image in the first display area 240. For example, the one of the first pixel sets 244 used as the first display unit includes four first pixels 242 with the same color or sixteen first pixels 242 with the same color. For another example, the one of the first pixel sets 244 used as the first display unit includes a plurality of first pixels 242 with different colors. Multiple of the second pixels 222 in the second display area 220 can form a second display unit or a second pixel unit. For example, the second pixel unit in the second display area 220 includes a red pixel, a green pixel, and a blue pixel. Certainly, the second pixel unit of the second display area 220 can also include other pixels, such as a white pixel or a yellow pixel.

In the embodiment of the present disclosure, multiple of the first pixel sets 244 can also be used as a first display unit. For example, three of the first pixel sets 244 can be used as a first display unit. For another example, four of the first pixel sets 244 can be used as a light transmitting display unit. One of the first pixel sets 244 in the first display unit can include four first pixels 242 with the same color or sixteen first pixels 242 with the same color. For example, a first display unit includes three of the first pixel sets 244. One of the three first pixel sets 244 includes four red pixels, another first pixel set 244 includes four green pixels, and the other first pixel set 244 includes four blue pixels.

Please refer to FIG. 6. FIG. 6 illustrates a first arrangement schematic diagram of a first display unit in the first display area of the display apparatus in FIG. 2. A first display unit 216a in the first display area 240 can include three first pixel sets 244 including a first pixel set 244a, a first pixel set 244b, and a first pixel set 244c. The first pixel set 244a can include four red pixels 242(R), the first pixel set 244b can include four green pixels 242(G), and the first pixel set 244c can include four blue pixels 242(B). It should be noted that the arrangement of the first pixel sets in one first display unit is not limited to this.

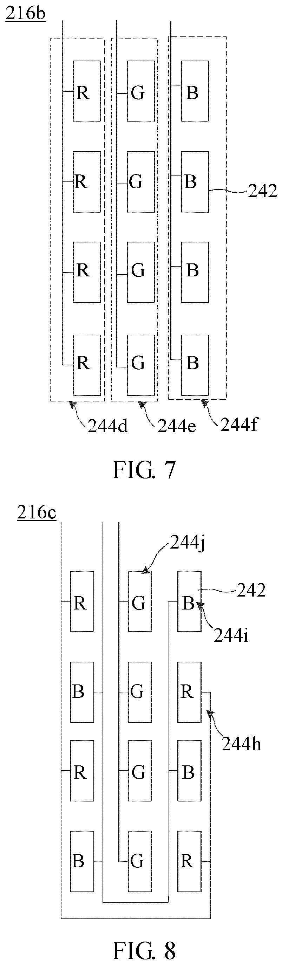

Please refer to FIG. 7. FIG. 7 illustrates a second arrangement schematic diagram of a first display unit in the first display area of the display apparatus in FIG. 2. A first display unit 216b in the first display area 240 can include three first pixel sets 244 including a first pixel set 244d, a first pixel set 244e, and a first pixel set 244f. The first pixel set 244d can include four red pixels 242, the first pixel set 244e can include four green pixels 242, and the first pixel set 244f can include four blue pixels 242.

Please refer to FIG. 8. FIG. 8 illustrates a third arrangement schematic diagram of a first display unit in the first display area of the display apparatus in FIG. 2. A first display unit 216c in the first display area 240 can include three first pixel sets 244 including a first pixel set 244h, a first pixel set 244i, and a first pixel set 244j. The first pixel set 244h can include four red pixels 242, the first pixel set 244i can include four green pixels 242, and the first pixel set 244j can include four blue pixels 242.

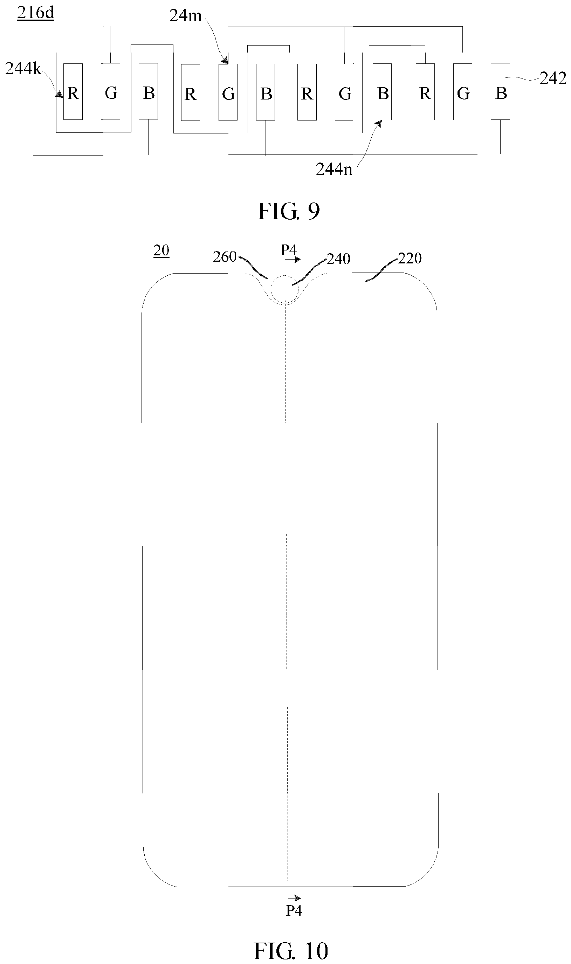

Please refer to FIG. 9. FIG. 9 illustrates a fourth arrangement schematic diagram of a first display unit in the first display area of the display apparatus in FIG. 2. A first display unit 216d in the first display area 240 can include three first pixel sets 244 including a first pixel set 244k, a first pixel set 244m, and a first pixel set 244n. The first pixel set 244k can include four red pixels 242, the first pixel set 244m can include four green pixels 242, and the first pixel set 244n can include four blue pixels 242.

It can be understood that when a first display unit in the first display area 240 includes four first pixel sets 244, the first pixels included in each of the four first pixel sets 244 242 have the same color. For example, a first one of the pixel sets 244 includes a plurality of red pixels, a second one of the first pixel sets 244 includes a plurality of green pixels, a third one of the first pixel sets 244 includes a plurality of blue pixels, and a fourth one of the first pixel sets 244 includes a plurality of white pixels or the fourth one of the first pixel sets 244 includes a plurality of yellow pixels.

FIGs. 6 to 9 only illustrate several arrangements of a first display unit in the first display area 240 of the display apparatus 20. Other arrangements of a first display unit in the first display area 240 are also possible in the embodiment of the present disclosure.

It should be noted that in some solutions, in order to increase the light transmittance of the first display area, the size of each of the first pixels in the first display area can be larger than the size of each of the second pixels in the second display area, and the arrangement of the first pixels in the first display area is sparse than the arrangement of the second pixels in the second display area. As such, the first pixels in the first display area and the second pixels in the second display area have different pixel physical structures. In an actual process, since the first pixels in the first display area and the second pixels in the second display area have different pixel physical structures, it is necessary to use different masks to form the pixel structures by a series of processes (such as exposure, development, cleaning or the like). For example, the first pixels in the first display area are formed by a first type of mask through a first set of processes, and the second pixels in the second display area are formed by a second type of mask through a second set of processes. Not only additional masks and tools are required, but also the processes are increased. Accordingly, a processing cost and complexity are increased. This results in a reduced pixel yield after the pixels are formed.

In order to save tools and processes, the first pixels in the first display area and the second pixels in the second display area can be formed under the same process and the same mask (such as tools), so that the first pixels in the first display area and the second pixel in the second display area have the same pixel physical structure. However, when the first pixels in the first display area and the second pixel in the second display area have the same pixel physical structure and the first pixels in the first display area and the second pixel in the second display area have the same drive method, it is necessary to arrange many wirings and the first drive units in the first display area. The wirings affect the light transmittance of the first display area.

Based on the related schemes, in order to solve the processes and the process cost, an arrangement of signal lines in the first display area can also be reduced to facilitate the arrangement of the lines in the first display area and increase the light transmittance of the first display area. In the embodiment of the present disclosure, at least two pixels in the first display area are connected in parallel to form a first pixel group. After multiple first pixels are connected in parallel, they can be connected to the same signal line. Compared with connecting a signal line to each first pixel, a number of the signal lines can be greatly saved, the arrangement of the signal lines is convenient, and the light transmittance of first display area can be increased.

Accordingly, in the embodiment of the present disclosure, at least two first pixels are connected in parallel in the first display area to form a first pixel group. Based on the premise that the pixel physical structure of the display apparatus is not changed, the number of the signal lines arranged at the position corresponding to the first display area can be reduced significantly by changing wirings in the display layer corresponding to a position of first display area, thereby increasing the light transmittance of the first display area.

In order to further increase the light transmittance of the first display area 240, a portion of the first drive units for driving the first display area 240 can be disposed in the first display area 240, and the other portion of the first drive units can be arranged in other position, (such as in the second display area 220). For example, a portion of the first drive units are disposed in the first drive part 234, and the other portion of the first drive units are disposed in the second drive part 232.

Certainly, in the embodiment of the present disclosure, all of the first drive units for driving the first display area 240 can also be arranged in other position. For example, all of the first drive units can be disposed in the second display area 220.

It should be noted that when the first drive units 246 for driving the first pixels 242 in the first display area 240 are disposed in the second display area 220 (such as the second drive part 232), it is necessary to arrange wirings. It is considered that the wirings occupy the space where the first display area 240 and the second display area 220 are connected. When there are too many wirings, the space may not be enough for arrangement and it is necessary to increase a thickness to arrange more wirings. In order not to increase the thickness for arranging the wirings and to ensure that there is enough space for the wirings where the first display area 240 and the second display area 220, at least two first pixels 242 in the first display area 240 can be connected in parallel to form a first pixel set 244 and connected to the same signal line. The number of the signal lines can be reduced significantly, and the space occupied by the signal lines can be reduced. As such, the drive units 246 for driving the first pixels 242 in the first display area 240 can be disposed in the second display area 220.

However, it is considered that the second display area 220 is the main display portion of the display apparatus 20. When all of the first drive units 246 for driving the first display area 240 are disposed in the second display area 220, disposing the second drive part 232 in the second display area 240 is affected and a wiring process of the second drive part 232 is affected. This may affect quality and effect of an image displayed in the second display area 220. To this end, in order to reduce influence of the first drive units 246 on the second display area 220 in the embodiment of the present disclosure, a third display area can be disposed between the second display area 220 and the first display area 240 to form a transition area, so as to dispose the first drive units in the third display area to reduce the influence of the first drive unit 246 on the second display area 220.

Please refer to FIG. 10. FIG. 10 illustrates another structural schematic diagram of a display apparatus provided by an embodiment of the present disclosure. The display device 20 can further include a third display area 260, which can also be referred to as a transition area. The third display area 260 can connect the second display area 220 to the first display area 240. The third display area 260 can be connected between the second display area 220 and the first display area 240. In the embodiment of the present disclosure, the third display area 260 can separate the second display area 220 from the first display area 240, so that the second display area is not directly connected. In the embodiment of the present disclosure, the third display area 260 can also be connected to a portion of the second display area 220 and the first display area 240, and the other portion of the second display area 220 and the first display area 240 can also be directly connected. A size of the third display area 260 can be much smaller than a size of the second display area 220. The first display area 240 and the third display area 260 can together form an auxiliary display area of the display apparatus 20. Herein, the first display area 240 and the third display area 260 can be defined as an auxiliary display area or an assisting display area.

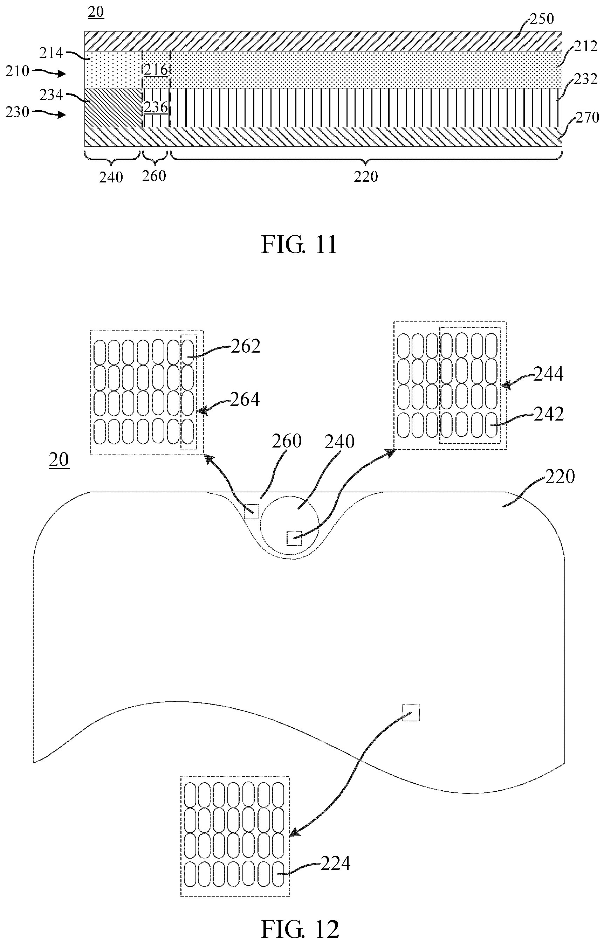

Please refer to FIG. 11. FIG. 11 illustrates a cross-sectional view of the display apparatus along a direction P4-P4 in FIG. 10. The display layer 210 can further include a third display portion 216 located in the third display area 260. The third display portion 216 can be arranged with a plurality of third pixels. An arrangement of the third pixels can be one of a standard RGB arrangement, a Pentile arrangement, or a Delta arrangement. Certainly, the third pixels can also adopt other arrangements. The drive layer 230 can further include a third drive portion 236. The third drive portion 236 can be provided with a plurality of drive units. For example, the third drive part 236 can be provided with a plurality of third drive units. Each of the third drive units can be electrically connected to one of the third pixels. Each of the third drive units can drive one of the third pixels. Each of the third drive units can adopt one of 2T1C, 5T1C, and 7T1C. For example, each of the drive units can adopt 5T1C. In the embodiment of the present disclosure, 5T1C can be used for the third display area 260, 2T1C can be used for the first display area 240, and 7T1C can be used for the second display area 220. As such, quality of an image displayed in the second display area 220 can be higher than quality of an image displayed in the third display area 260, and quality of an image displayed in the third display area 260 is higher than quality of an image displayed in the first display area 240, so that a transition area is presented between the first display area 240 and the second display area 220.

Certainly, drive methods of the first display area 240, the second display area 220, and the third display area 260 are not limited to this. For example, 5T1C can be used for the first display area 240 and the third display area 260, and 7T1C can be used for the second display area 220.

Please refer to FIG. 12. FIG. 12 illustrates a first partial schematic diagram of the display apparatus in FIG. 10. An arrangement of the third pixels 262 in the third display area 260 can be the same as an arrangement of the second pixels 224 in the second display area 220 and can also be the same as an arrangement of the first pixels 242 in the first display area 240. For example, the pixels in the second display area 220, the third display area 260, and the first display area 240 have the same physical structure, and the pixels in the second display area 220, the third display area 260, and the first display area 240 can be formed in the same process. It should be noted that the arrangement of the third pixels 262 in the third display area 260 can also be different from the arrangement of the second pixels 224 in the second display area 220 or the arrangement of the first pixels 242 in the first display area 240. It should be noted that FIG. 11 only illustrates some pixels of the display apparatus 20, and an area formed by the arrangement of the first pixels 242, an area formed by the arrangement of the third pixels 262, and an area formed by the arrangement of the second pixels 222 in FIG. 11 are approximately the same.

In the embodiment of the present disclosure, all of the first drive units for driving the first display area 240 can be disposed in the third display area 260. For example, the first drive units can be disposed in the third display portion 236. As such, there is no first drive unit disposed in the drive layer structure in the first display area 240. For example, there is no thin film transistor in the first drive portion 234 of the first display area 240. This can improve the light transmittance of the first display area 240 significantly. Furthermore, other problems caused by disposing the first drive units in the first display area 240 can be avoided. For example, a diffraction problem on the imaging of the camera 60 caused by the periodically arranged first drive units can be avoided, or a stray light problem on the imaging of the camera 60 caused by reflection and refraction of the first drive units can be avoided.

It should be noted that since the third display area 260 is provided with a plurality of third drive units, the third drive units occupy space of the third drive portion 236. In the present disclosure, the first drive units disposed in the third drive portion 236 also occupy the space of the third drive portion 236, and wirings also occupy the space of the third drive portion 236. In order to ensure that the first drive units can be disposed in the third drive portion 236, the wirings of the third drive portion 236 can be thinner, so as to reduce space occupied by a single signal line to accommodate an arrangement of more signal lines.

Certainly, in the embodiment of the present disclosure, the first drive units can also be disposed, without changing the thickness of the wirings in the third drive portion 236, in the third drive portion 236 to satisfy the wirings. A number of the third drive units in the third display area 260 is reduced

Please continue to refer to FIG. 12. A plurality of third pixel sets 264 can be disposed in the third display area 260. Each of the third pixel sets 264 can include at least two third pixels 262 connected in parallel and can include at least two third pixels with the same color (such as red pixels). One of the third pixel sets 264 can also include at least two third pixels 262 with different colors (such as a red pixel and a green pixel). Multiple of the third pixels 262 in one of the third pixel sets 264 can be connected together by a plurality of signal lines. A number of the third pixels 262 in one of the third pixel sets 264 can be greater than a number of the first pixels 242 in one of the first pixel sets 244. For example, one of the third pixel sets 264 includes four third pixels 262, and one of the first pixel sets 244 includes sixteen first pixels 242. Certainly, the number of the third pixels 262 in one of the third pixel sets 264 can be the same as the number of the first pixels 242 in one of the first pixel sets 244.

In the embodiment of the present disclosure, one of the third pixel sets 264 can be used as a third display unit of the third display area 260. For example, the one of the third pixel sets 264 used as the third display unit includes two third pixels 262 with the same color or four third pixels 262 with the same color. For another example, the one of the third pixel sets 264 used as the third display unit includes a plurality of third pixels 262 with different colors.

In the embodiment of the present disclosure, multiple third pixel sets 264 can also be used as a third display unit. For example, three of the third pixel sets 264 can be used as a third display unit. For another example, four of the third pixel sets 264 can be used as a third display unit. One of the third pixel sets 264 in the third display unit can include two third pixels 262 with the same color or four third pixels 262 with the same color. For example, a third display unit includes three third of the pixel sets 264. One of the three third pixel sets 264 includes four red pixels, another third pixel set 264 includes four green pixels, and the other third pixel set 264 includes four blue pixels. A number of the third pixel sets 264 included in a third display unit and an arrangement of the third pixels 262 in the third display unit can be referred to the structures of the first display units in FIGs. 6 to 9, and thus details are not repeated herein.

It can be understood that when a third display unit in the third display area 260 includes four third pixel sets 264, the third pixels 262 included in each of the four third pixel sets 264 have the same color. For example, a first one of the third pixel sets 264 includes a plurality of red pixels, a second one of the third pixel sets 264 includes a plurality of green pixels, a third one of the third pixel sets 264 includes a plurality of blue pixels, and a fourth one of the third pixel sets 264 includes a plurality of blue pixels, and a fourth one of the third pixel sets 264 includes a plurality of white pixels or the fourth one of the third pixel sets 264 includes a plurality of yellow pixels.

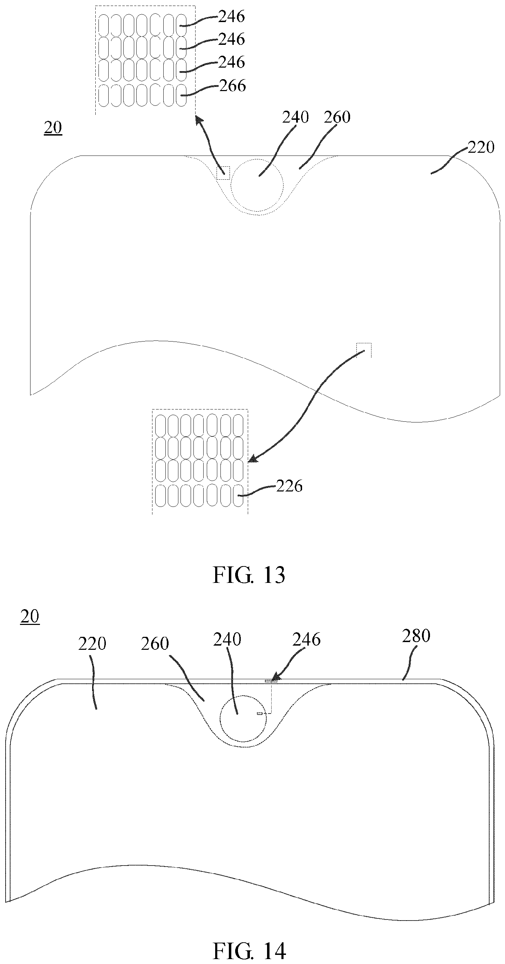

Please refer to FIG. 13. FIG. 13 illustrates a second partial schematic diagram of the display apparatus in FIG. 10. FIG. 13 illustrates a plurality of second drive units 224 in the second display area 220 and a plurality of third drive units 266 and a plurality of first pixel units 246 in the third display area 260. The second drive units 224 can be referred to the content shown in FIG. 5, and details are not repeated herein. The third drive units 266 and the second display units 246 are located in the third display area 260 (such as disposed in the third drive part 236).

The third drive units 266 are used for driving the third display area 260. Each of the third drive units 266 can be electrically connected to one of the third pixel sets 264. Each of the third drive units 266 can drive one of the third pixel sets 264. That is, each of the third drive units 266 can drive all the third pixels 262 in the one of the third pixel sets 264. Compared with one drive unit driving one pixel, a number of the third drive units can be reduced in the embodiment of the present disclosure, thereby reducing space occupation of the third drive portion 236 by the third drive units and disposing the first drive units 246. For example, one of the third pixel sets 264 includes four third pixels 262 connected in parallel. One of the third drive unit 266 can occupy space corresponding to one of the third pixels 262 or slightly smaller than space corresponding to one of the third pixels 262. Therefore, space corresponding to at least three of the third pixels 262 can be vacated in one of the third pixel sets 264, and multiple of the first pixel units 264 (such as three first drive units 246) can be disposed in the vacant space. The three third pixels 262 can be set with the three first drive units 246 in a one-to-one correspondence.

Accordingly, in the embodiment of the present disclosure, at least two third pixels 262 in the third display area 260 can be connected in parallel to form a third pixel set 264, and a third drive unit 266 can be used for realizing to drive multiple third pixels 262. The first drive units 246 can be disposed in sufficient space in the third drive portion 236. As such, opaque thin film transistors in the first display area 240 can be disposed in the third display area 260 where it is not required collecting a light signal by the camera, and a size of the third display area 260 can be smaller and connect the first display area 240 with the second display area 220. Under a situation that an image displayed in the second display area 220 is not greatly affected, deterioration of quality of an image displayed in the third display area 260 does not has a big impact on display effect of the entire display apparatus 20.

Furthermore, a number of the third pixels 262 connected in parallel in the third display area 260 can be smaller than a number of the first pixels 242 connected in parallel in the first display area 240, so that a display transition between the first display area 240 and the second display areas 220 is smoother.

It should be noted that positions where the first drive unit are disposed is not limited to the third display area 260 in the embodiment of the present disclosure. For example, a portion of the first drive units are disposed in the third display area 260, and the other portion of the first drive units are disposed in the first display area 240. For another example, a portion of the first drive units are disposed in the third display area 260, and the other portion of the first drive units are disposed in the second display area 220. For yet another example, the first drive units are divided into three portions which are respectively disposed in the first display area 240, the third display area 260, and the second display area 220.

It should also be noted that the positions where the first drive units are disposed in the embodiment of the present disclosure are not limited to the display areas, and the first drive unit can also be disposed in a side or a non-display area of the display apparatus 20.

Please refer to FIG. 14. FIG. 14 illustrates a third partial schematic diagram of the display device in FIG. 10. The display apparatus 20 can further include a non-display area 280. The first drive units 246 for driving the first display area 240 can be disposed in the non-display area 280. The display apparatus 20 can be a full screen. That is, a front surface of the display apparatus 20 is basically a display area. The front surface of the display apparatus 20 is basically equal to the display surface of the electronic device from the view of the front surface of the electronic device. However, even if the display apparatus 20 is a full screen, there still exists the non-display area 280 at an edge of the display apparatus 20. The non-display area 280 can be understood as a black border of the display apparatus 20, and a width of the black border can be made very narrow. For example, the width of the black border is less than 1 mm or 0.5 mm. Since an area of the first display area 240 is small, the number of the first pixels in the first display area 240 is relatively small. The first pixels in the first display area 240 can be connected in parallel, and the first drive units 246 for driving the first area 240 are reduced. As such, the first drive units 246 can be disposed in a position of the black border to increase the light transmittance of the first display area 240 without affecting the second display area 220 or the third display area 260. Multiple first drive units 246 corresponding to the first pixels in the first display area 240 are required to be disposed, and thus all the first drive units 246 can be disposed in the position of the black border.

In order to better accommodate all the first drive units 246 in the position of the black border, simpler first drive units 246 can be used. For example, the first drive units 246 can adopt drive circuits such as 2T1C or 5T1C. Accordingly, a number of thin film transistors in each of the drive units 246 is small, and a single first drive unit 246 requires less space. A distribution density of the first pixels in the first display area 240 can also be set to be lower, and thus a total number of the first drive units 246 used for driving the first display area 240 is smaller. It should be noted that a portion of the first drive units 246 can also be disposed in the non-display area 280, and the other portion of the first drive units are disposed in other position (such as the first display area 240 or the third display area 260).

It should be noted that the method of increasing the light transmittance of the first display area 240 in the embodiment of the present disclosure is not limited to this, and other methods can also be used. For example, the wirings of the display apparatus 20 in the first display area 240 can be disposed in a transparent structure, so as to increase the light transmittance of the first display area 240. For another example, a polarizing structure is not provided in the first display area 240. For yet another example, the drive units which drive the first display area 240 can be driven by a passive drive method. This can reduce wirings and components in the drive units significantly. It can be understood that solution of increasing the first display area 240 by increasing a light transmittance of a material and changing an arrangement of the wirings are within the scope of the present disclosure.

However, it should be understood that since each of the drive units can include a plurality of devices such as a plurality of TFTs and capacitors. In order to improve the light transmittance of the first display area 240, the entire structure of each of the drive units can be disposed in the first display area 240, or a portion of the structure of each of the drive units can be disposed outside the first display area 240. Generally, each of the drive units (such as the first drive unit 246) can include a plurality of TFTs and one or two capacitors. For example, at least one TFT in each of the first drive units 246 can be disposed outside the first display area 240, and the one or two capacitors can be disposed in the first display area 240. Specifically, all the TFTs can be disposed outside the first display area 240, and only the one or two capacitors can disposed in the first display area 240. Alternatively, a portion of the TFTs can be disposed in the first display area 240, and the other portions of the TFTs can be disposed outside the first display area 240.

It should be noted that the outside of the first display area 240 can be at least one of the second display area 220, the third display area 260, and the non-display area. The non-display area can include a side of the display apparatus 20, the side can be a side of the first display area 240, or a side of the second display area 220. Certainly, a portion of the side can be the side of the first display area 240, and the other portion of the side is the side of the second display area 220. It can be understood that the non-display area can also include the above-mentioned black border.

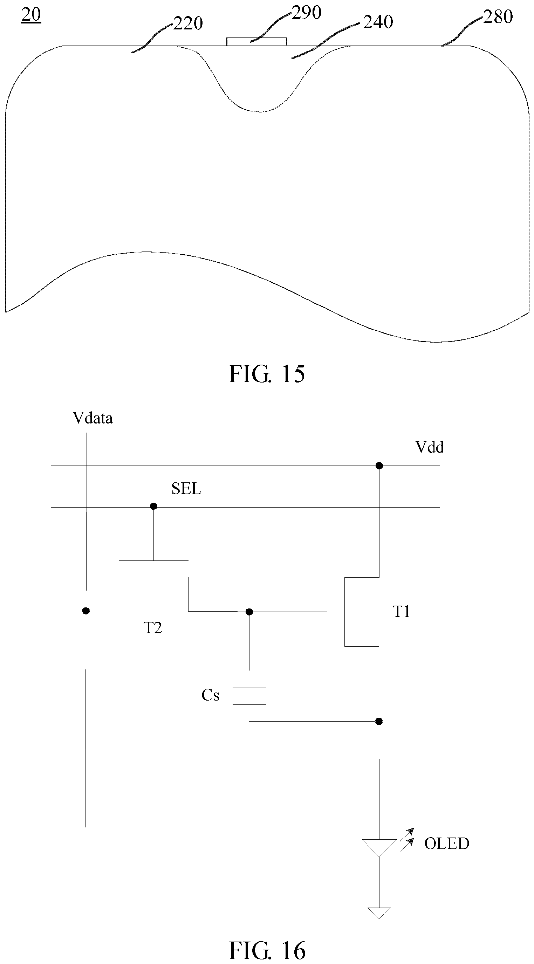

Please refer to FIG. 15. FIG. 15 illustrates a partial schematic view of the display apparatus provided by an embodiment of the present disclosure. The display apparatus 20 can further include a side edge 280. It should be understood that the side edge 280 of the display apparatus 20 can also be referred to as a side portion, a side edge or the like of the display apparatus 20. The side edge 280 is located at an edge of the display apparatus. In other words, the side edge 280 is located around the display area of the display apparatus 20. The display apparatus 20 can have one or more side edges 280, and a number of the side edges 280 is not limited herein.

In the embodiment of the present disclosure, a portion or all of a circuit structure in the first display area 240 can be disposed in the side edge 280. For example, a flexible circuit board 290 is disposed in the side edge 280. The flexible circuit board 290 can be disposed corresponding to the first display area 240. In other words, the flexible circuit board 290 can be disposed in a side of the first display area 240. Certainly, the flexible circuit board 290 can also be disposed in a position corresponding to the second display area 220. In other words, the flexible circuit board 290 can be disposed in a side of the second display area 220. It can be understood that a portion of the flexible circuit board 290 can also be disposed in a side of the first display area 240, and the other portion of the flexible circuit board 290 can also be disposed in a side of the second display area 220. The flexible circuit board 290 can extend to the inside of the first display area 240. For example, the flexible circuit board 290 extends from the drive layer or the drive portion in the first display area 240 to the inside of the first display area 240, so as to realize connections of the circuit.

In the embodiment of the present disclosure, at least one thin film transistor of one first drive unit for driving the first display area 240 can be disposed in the side edge 280, and the thin film transistor of the one first drive unit can use the first flexible circuit board 290 as a carrier for driving the first pixels in the first display area 240. Since the flexible circuit board 290 can be disposed in the side of the first display area 240 or the side of the second display area 220 or the flexible circuit board 290 can be disposed in the sides of the first display area 240 and the second display area 220, the at least one thin film transistor of the one first drive unit can be disposed in the side of the first display area 240 or the side of the second display area 220 or the at least one thin film transistor of the first drive unit can be disposed in the sides of the first display area 240 and the second display area 220. In some embodiments, all thin film transistors of the first drive unit can be disposed in the side edge 280.

It should be noted that space of the side edge 280 of the display apparatus 20 is limited. In particular, the display apparatus 20 is often relatively thin, and space in a thickness direction thereof is even more limited. Accordingly, it is often difficult to disposing many circuit structures in the side of the display apparatus 20. As such, a portion of the thin film transistors of the first drive unit can be disposed in the side edge 280, and the other portion of the thin film transistors are disposed in the first display area 240.

It can be understood that the thin film transistors of the first drive unit are often divided into different types. For example, the thin film transistors of the first drive unit can include at least one drive transistor and at least one control transistor. The control transistor can be electrically connected to a gate line (or referred to as a scan line) of the display apparatus 20. It can also be understood that the display apparatus 20 includes a plurality of gate lines and a plurality of data lines. The gate lines and the data lines can be disposed in different layers of the display apparatus 20 and arranged interlacedly. For example, the gate lines are arranged in rows, and the data lines are arranged in columns. One of the data lines and one of the gate lines can be connected to different positions of one drive unit to realize cooperation to drive one pixel. For example, one of the data lines and one of the gate lines are connected to different positions of one drive unit to realize cooperation to drive one of the first pixels in the first display area 240.

In the embodiment of the present disclosure, one type of thin film transistors can be disposed in the first display area 240, and another type of thin film transistors can be disposed in the side edge 280. For example, in the embodiment of the present disclosure, all drive transistors of the first drive units can be disposed in the first display area 240. All drive transistors of one of the first drive units can correspond to one of the first pixels. For example, projections of all the drive transistors of the one of the first drive units on the display apparatus 20 are located within a projection of the one of the first pixels on the display device 20. All control transistors of the one of the first drive units can be disposed in the side edge 280 (such as in the flexible circuit board 290 corresponding to the side of the first display area 240). In the embodiment of the present disclosure, all drive transistors and all capacitors of the same first drive unit can also be disposed in the first display area 240 and correspond to one of the first pixels. For example, projections of all drive transistors and all capacitors of one of the first drive units on the display apparatus 20 are located within a projection of one of the first pixels on the display device 20.

In order to more fully understand the arrangement of the thin film transistors of one first drive unit in the embodiment of the present disclosure, the following descriptions will be given by taking one first drive unit as 7T1C, 5T2C, and 2T1C as examples.

Please refer to FIG. 16. FIG. 16 illustrates a first circuit schematic diagram of one first drive unit in the display apparatus provided by an embodiment of the present disclosure. The first drive unit can be 2T1C. T1 is a drive transistor, T2 is a control transistor, Vdata is connected to a data line, Vdd is connected to a voltage source, SEL is a gate line, OLED is a pixel, and OLED is a first pixel.

The first drive unit can include a plurality of thin film transistors (T1 and T2). The thin film transistors can include the drive transistor T1 and the control transistor T2. A gate electrode of the control transistor T2 is electrically connected to the gate line SEL. It can also be understood that the thin film transistors in the first drive unit can be divided into two types. One type is a drive transistor, and the other type is a control transistor. When a gate electrode of a thin film transistor in the first drive unit is electrically connected to the gate line SEL, the thin film transistor the control transistor T2. A thin film transistor in the first drive unit excluded the control transistor T2 is the drive transistor T1.

In the embodiment of the present disclosure, the drive transistor T1 can be disposed in the first display area 240, and the control transistor T2 can be disposed outside the first display area 240. Each of the first pixels 242 in the first display area 240 is connected to a power supply voltage through a wiring. When the wiring is longer, a resistance value of the wiring is greater. Inevitably, the power supply voltage produces a voltage drop (IR Drop) on the wiring. The resistance values of the wirings make the power supply voltage obtained by each of the first drive units different. Accordingly, under a voltage input with the same data signal, different first pixels 242 have different currents and brightness outputs. This results in non-uniform display brightness of the entire display device. Furthermore, voltage drops of the first pixels are also different for different images. The control transistor in the first drive unit mainly plays a control role and is not sensitive to the IR voltage drop and is disposed outside the first display area 240. That is, even if the IR voltage drop between the power supply voltage and the voltage signal of the control transistor is large, turn-on and turn-off of the control transistor are not affected and color compensation in the first display area 240 is not affected. The drive transistor T1 in the first drive unit mainly plays a role of driving the first pixel 242 and is disposed in the first display area 240 and is close to the first pixel 242. The voltage drop is relatively small. That is, the voltage drop between the power supply voltage and the voltage signal of the first pixel 242 is small. It is easier to compensate the color in the first display area 240.

It should be noted that a capacitor Cs in the first drive unit is disposed adjacent to the drive transistor T1. That is, both of the capacitor Cs and the drive transistor T1 can be disposed in the first display area 240 (such as the first drive portion of the drive layer).

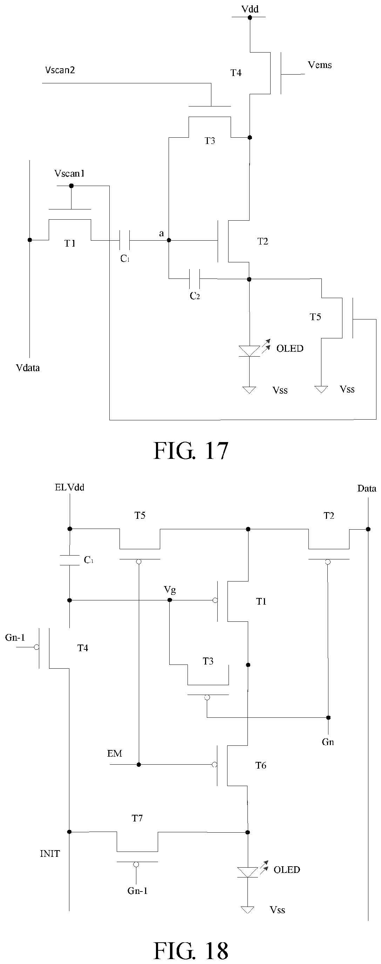

The first drive unit can also be 5T2C. Please refer to FIG. 17 for details. FIG. 17 illustrates a second circuit schematic diagram of one first drive unit in the display device provided by an embodiment of the present disclosure. T1, T3, and T5 in the first drive unit are control transistors, and T2 and T4 in the first drive unit are drive transistors. In FIG. 17, Vscan1 and Vsacan2 are connected to different gate lines, Vdata is connected to a data line, Vdd is connected to a voltage source, Vems is connected to a light-emitting scan control line, and OLED is a first pixel.

It should be noted that capacitors C1 and C2 in the first drive unit are disposed adjacent to the drive transistors. That is, the capacitors C1 and C2 and the drive transistors T2 and T4 are all disposed in the first display area 240.

A basic working principle of the first drive unit adopting 5T2C can be described as follows.

In a Reset stage, T1 is turned on, T4 is turned on, T3 is turned on, T2 is turned on, T5 is turned on, and a current charges the capacitor C2 through T3 and T4. Since T5 is turned on, OLED does not emit light.

In a threshold voltage storage stage, T1, T2, T3, T5 are turned on, T4 is turned off, and Vdata is 0. A voltage at a point a is discharged to Va=Vth through T3, T2, and T5. Since T5 is turned on, OLED does not emit light. Vth is a threshold voltage of a thin film transistor.

In a data voltage writing stage, T1, T2, and T5 are turned on, T3 and T4 are turned off, a gray-scale data voltage jumps to a positive value, and the gray-scale data is coupled to T2 through C1, and at this time Va=Vth+Vdata^{∗}C1/(C1+C2). Since T5 is turned on, OLED does not emit light.

In a light-emitting stage, T2 and T4 are turned on, T1, T3, and T5 are turned off, and T2 drives OLED to emit light. The voltage Va=Vth+Vdata^{∗}C1/(C1+C2) stored in C2 remains unchanged, so that brightness of OLED remains unchanged in one frame.

The first drive unit can also be 7T1C. Please refer to FIG. 18 for details. FIG. 18 illustrates a third circuit schematic diagram of one first drive unit in the display device provided by an embodiment of the present disclosure. T2, T3, T4, and T7 in the first drive unit are control transistor, and T1, T5 and T6 in the first drive unit are drive transistor. In FIG. 18, Gn-1 and Gn are connected to different gate lines, Data is connected to a data line, ELVdd is connected to a voltage source, and EM is connected to a light-emitting scan control line.

It should be noted that a capacitor C1 in the first drive unit is disposed adjacent to the drive transistors. That is, the capacitor C1 and the drive transistors T1, T5, and T6 are all disposed in in the first display area.

A basic working principle of the first drive unit adopting 7T1C can be described as follows.

In a capacitor discharging stage, Gn-1 is at a low voltage potential, T4 is turned on, INIT is at a low voltage potential, and the capacitor C1 is discharged.

In a compensation stage, Gn is at a low voltage potential, T2 and T3 are turned on, and a drain electrode and a gate electrode of T1 are short-circuited. Since Vg>Vth, T1 is turned on until vg=Vdata-Vth. Vth is a threshold voltage of a thin film transistor.

In a lght-emitting stage, EM is at a low voltage potential, T5 and T6 are turned on, and Vgs=ELVDD-(Vdata-Vth).

T2, T3, T4, and T7 are mainly used for reset and control, and an actual drive path includes T1, T5, and T6. The first drive unit adopting 7T1C can eliminate the dispersion of the Vth of the thin film transistor in the 2T1C drive circuit and solve a problem of uneven brightness distribution of the display device.

It should be noted that the capacitor C1 in the first drive unit is disposed adjacent to the drive transistors. That is, the capacitor C1 and the drive transistors T1, T5, and T6 are all disposed in the first drive circuit layer of the first display area.

Accordingly, in the embodiment of the present disclosure, a portion of the thin film transistors used for driving the first display area 240 can be disposed in the first display area 240, and the other portion of the thin film transistors can be disposed outside the first display area 240. This not only can reduce the number of the thin film transistors in the first display area 240, but also can reduce the wirings in the first display area 240, thereby increasing the light transmittance of the first display area 240 significantly. Furthermore, since a portion of the wirings and a portion of the thin film transistors for driving the first display area 240 are be disposed outside the first display area 240 (such as the side of the display apparatus 20), the arrangement of devices and wirings can be realized in the case of insufficient space of the side.

The second display area 220 in the embodiment of the present disclosure can be an actively driven (AMOLED) display area, and the first display area 240 can be an actively driven display area or a passively driven (PMOLED) display area. In the embodiment of the present disclosure, the first display area 240 can be set to be smaller than the second display area 220, so that content displayed in the first display area 240 is less than content displayed in the second display area 220. Importance of the content displayed in the first display area 240 is lower than importance of the content displayed in the second display area 220. Accordingly, adopting AMOLED for the second display area 220 in the embodiment of the present disclosure can ensure that the main display area of the display apparatus 20 can have higher display effect. Meanwhile, the first display area 240 adopts PMOLED. Only one thin film transistor is required for driving the passively driven first display area 240 which is passively driven, and the number of opaque thin film transistors is small. This can increase the light transmittance of the first display area 240 significantly. Furthermore, an area displayed by the first display area 240 can be much smaller than an area displayed by the second display area 220. When quality of an image displayed in the first display area 240 decreases, the entire display of the display apparatus 20 is not affected significantly. It should be noted that the first display area 240 can also be actively driven, so that the display effect of the first display area 240 can be close to the display effect of the second display area 220.

In the embodiment of the present disclosure, the third display area 260 can be selected as an actively driven display area or a passively driven display area as required. Since the physical structures of the third pixels 262 in the third display area 260 and the first pixels 242 in the first display area 240 are the same, the third display area 260 and the first display area 240 can be driven in the same manner. For example, the third display area 260 and the first display area 240 can be passively driven display areas. When an area of the third display area 260 is larger the display quality of the third display area 260 is required to be increased, the third display area 260 and the second display area 220 can use the same drive display area. For example, they can be actively driven display areas.

The size and the shape of each of the first pixels 242 in the first display area 240 can be set as required. For example, each of the first pixels 242 can be a rectangle or a circle-like shape. The first pixel 242 which is circle-like can be a circle, an ellipse, a rounded rectangle or the like. The first pixel 242 which is circle-like can improve the diffraction problem of the first display area 240 because an edge is an arc-shaped transition.

In the embodiment of the present disclosure, a sensor (such as the camera 60) of the electronic device 10 can be disposed inside the display apparatus 20. For example, a lens of the camera 60 faces the lower substrate 270 of the display apparatus 20, and the camera 60 is disposed corresponding to the first display area 240. In other words, the camera 60 is located below the lower substrate 270 corresponding to the first display area 240. The camera 60 can acquire an external light signal passing through the first display area 240 for imaging. In the embodiment of the present disclosure, the lens of the camera 60 and the lower substrate 270 can be disposed separately. Certainly, the lens of the camera 60 can also share the lower substrate 270. For example, a position of the lower substrate 270 corresponding to the first display area 240 is formed in an arc-shaped structure.

In order to reduce space of the electronic device 10 occupied by the camera 60, the lens of the camera 60 can be close to or adjacent to the lower substrate 270 of the display device 20. The lower substrate 270 of the display device 20 is mainly used for supporting other layer structures of the display apparatus 20 and does not need any special function itself.

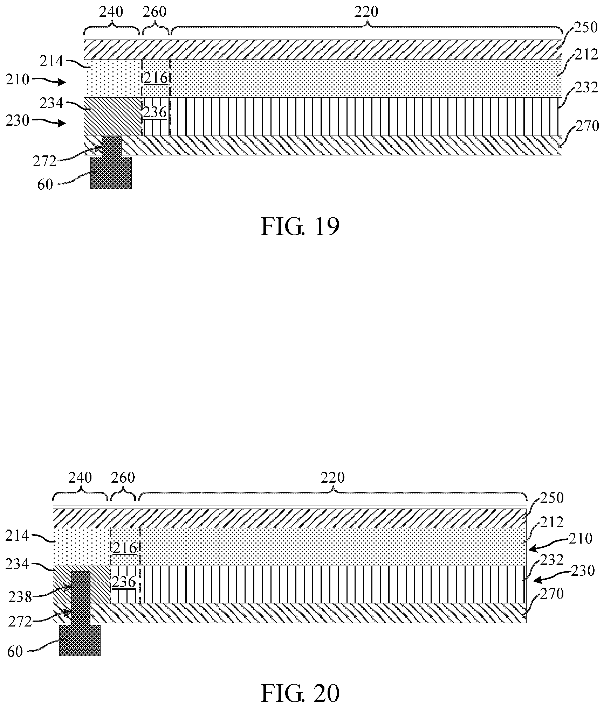

Please refer to FIG. 19. FIG. 19 illustrates a structural schematic structural diagram of the display apparatus and the camera in the electronic device provided by an embodiment of the present disclosure. In order to further reduce the inner space of the electronic device 10 occupied by the camera 60, a first mounting hole 272 can be provided on one side of the lower substrate 270 opposite to the camera 60, and the camera 60 can be at least partially disposed in the first mounting hole 272. The first mounting hole 272 can be a blind hole. That is, a thickness of a portion of the lower substrate 270 relative to the camera 60 is smaller than a thickness of the other portion. The lower substrate 270 is still a complete substrate. The function of supporting other layers of the display device 20 is not affected, and space can be vacated to accommodate the camera 60. An installation method of the first mounting hole 272 and the camera head 60 can be set according to a size of the first mounting hole 272 and a size of the camera 60. Exemplarily, when the space of the first mounting hole 272 is insufficient to accommodate the camera 60, the lens of the camera 60 can be disposed in the first mounting hole 272. When the camera is small enough, the whole of the camera head 60 can be disposed in the first mounting hole 272.

It should be noted that the camera can be replaced with other sensor of the electronic device 10. That is, at least a portion of a sensor of the electronic device 10 can be disposed in the first mounting hole 272.

Please refer to FIG. 20. FIG. 20 illustrates another structural schematic diagram of the display device and the camera in the electronic device according to an embodiment of the present disclosure. Since the drive layer 230 of the first display area 240 can exclude the first drive units disposed therein, the camera 60 can be disposed in the drive layer. Specifically, the first mounting hole 272 opened in the lower substrate 270 is a through hole. The drive layer corresponding to the first display area 240 has a second mounting hole 238 opposite to the camera 60. The first mounting hole 272 and the second mounting hole 238 communicate with each other. The camera 60 can be at least partially located in the second mounting hole 238. For example, the lens of the camera 60 is located in the first mounting hole 272 and the second mounting hole 238. The second mounting hole 238 can be a through hole or a blind hole. The first mounting hole 272 and the second mounting hole 238 can be fabricated after a portion of the layer-structure of the display apparatus 20 is formed. For example, after the drive layer 230 and the display layer 210 of the display apparatus 20 are disposed on the lower substrate 270, the first mounting hole 272 and the second mounting hole 238 are formed at locations corresponding to the lens position of the camera 60by laser or the like corresponding to the lens of the camera 60 by laser or the like.

It should be noted that the camera can be replaced with other sensors of the electronic device 10. That is, at least a portion of a sensor of the electronic device 10 can be disposed in the first mounting hole 272 and the second mounting hole 238.

It can be understood that the camera 60 relative to the first display area 240 can be used as a front camera of the electronic device. The front camera is generally a camera of which a lens cannot be moved. The first mounting hole and the second mounting hole can be disposed in the lower substrate and the drive layer of the display device 20. The camera 60 relative to the first display area 240 can be a camera with a movable lens, and the moved lens of the camera 60 can be moved to realize a function (such as auto-focusing). It should be noted that the camera 60 can also be a rear camera. That is, the electronic device 10 can be provided with two opposite display devices 20.

One camera 60 or multiple cameras 60 can be disposed below the first display area 240. The multiple cameras 60 can be cameras 60 which cooperate with each other. For example, two identical cameras include a common camera and a blur camera or a black and white camera or the like. Other sensors can be disposed below the first display area 240 in addition to the cameras.

The sensor in the embodiment of the present disclosure is not limited to a camera and can also be a proximity sensor, a light sensor, a ranging sensor, a fingerprint recognition sensor or the like.

The display device 20 in the embodiments of the present disclosure is not limited to the first display area 240 and the second display area 220 or the first display area 240, the second display area 220, and the third display area 260. The display device 20 defined in the embodiments of the present disclosure can also only have the first display area 240. That is, a portion of the TFTs in the entire display area in the embodiments of the present disclosure can be disposed outside the first display area 240. As such, the light transmittance of the entire display area can be increased, and a sensor (such as the camera 60) can be disposed in any position below the display apparatus 20.

Please continue to refer to FIG. 1. The electronic device 10 can further include a housing 40. The housing 40 can be formed by plastic, glass, ceramic, fiber composite, metal (such as stainless steel or aluminum), other suitable materials, or a combination of any two or more of these materials. The housing 40 can be formed by a unitary configuration. In the unitary configuration, some or all of the housing 40 is machined or molded into a single structure. Alternatively, multiple structures (such as inner frame structures, one or more structures for forming an outer shell surface or the like) can be used. The housing 40 can be provided with a receiving cavity to receive components of the electronic device 10 (such as a battery, a circuit board or the like). The housing 40 can also support the display device 20.

The display apparatus and the electronic device provided by the embodiments of the present disclosure are described in detail above. Although the principles and implementations of the present disclosure are described by specific examples in this specification, the above-mentioned descriptions of the embodiments are only intended to help understand the present disclosure. Moreover, those skilled in the art can make modifications to the specific implementations and an application range according to the idea of the present disclosure. In conclusion, the content of the specification is not intended to be construed as a limitation on the present disclosure.

## Claims

1. A display apparatus, comprising a first display area, the display apparatus further comprising:
a plurality of first pixels, wherein the first pixels are disposed in the first display area; and
a plurality of first drive units, wherein the first drive units are used for driving the first pixels, each of the first drive units comprises at least two thin film transistors, and at least one of the at least two thin film transistors of each of the first drive units is disposed outside the first display area.

2. The display apparatus of claim 1, wherein all of the at least two thin film transistors of each of the first drive units are disposed in a side of the first display area.

3. The display apparatus of claim 1, wherein the display apparatus further comprises a second display area, the second display area is adjacent to the first display area, and all of the at least two thin film transistors of each of the first drive units are disposed in a side of the second display area.

4. The display apparatus of claim 1, wherein the display apparatus further comprises a second display area, the second display area is adjacent to the first display area, a portion of all of the at least two thin film transistors of each of the first drive units are disposed in a side of the first display area, and the other portion of all of the at least two thin film transistors of each of the first drive units are disposed in a side of the second display area.

5. The display apparatus of claim 1, wherein the at least two thin film transistors of each of the first drive units comprise:
at least one control transistor, wherein the at least one control transistor is electrically connected to a gate electrode of the display apparatus, and all of the least one control transistor is disposed outside the first display area; and
at least one drive transistor, wherein all of the least one drive transistor is disposed in the first display area.

6. The display apparatus of claim 5, wherein all of the at least one drive transistor of each of the first drive units is disposed corresponding to one of the first pixels.

7. The display apparatus of claim 6, wherein a projection of all of the least one drive transistor on the display apparatus is located in a projection of the one of the first pixels on the display apparatus.

8. The display apparatus of claim 6, wherein each of the first drive units comprises at least one capacitor, the at least one capacitor is disposed in the first display area, and all of the least one capacitor and all of the at least one drive transistor of each of the first drive units are disposed corresponding to the one of the first pixels.

9. The display apparatus of claim 8, wherein projections of all of the least one capacitor and all of the least one drive transistor of each of the first drive units on the display apparatus are located in a projection of the one of the first pixels on the display apparatus.

10. The display apparatus of claim 8, wherein all of the at least one control transistor is disposed in a side of the first display area.

11. The display apparatus of claim 8, wherein the display apparatus further comprises a second display area, the second display area is adjacent to the first display area, and all of the at least control transistor is disposed in a side of the second display area.

12. The display apparatus of claim 8, wherein the display apparatus further comprises a second display area, the second display area is adjacent to the first display area, a portion of all of the at least one control transistor is disposed in a side of the first display area, and the other portion of all of the at least one control transistor is disposed in a side of the second display area.

13. The display apparatus of claim 1, wherein the first display area further comprises a plurality of pixel sets, each of the pixel sets comprises multiple of the first pixels connected in parallel, each of the pixel sets is electrically connected to one of the first drive units, and each of the first drive units is used for driving first pixels in one of the pixel sets.

14. An electronic device, comprising a display apparatus and a sensor, the display apparatus comprising a first display area, the display apparatus further comprising:
a plurality of first pixels, wherein the first pixels are disposed in the first display area; and
a plurality of first drive units, wherein the first drive units are used for driving the first pixels, each of the first drive units comprises at least two thin film transistors, and at least one of the at least two thin film transistors of each of the first drive units is disposed outside the first display area.

15. The electronic device of claim 14, wherein the at least two thin film transistors of each of the first drive units comprise:
at least one control transistor, wherein the at least one control transistor is electrically connected to a gate electrode of the display apparatus, and all of the least one control transistor is disposed outside the first display area;
at least one drive transistor, wherein all of the least one drive transistor is disposed in the first display area; and
at least one capacitor, wherein the at least one capacitor is disposed in the first display area, and all of the least one capacitor and all of the at least one drive transistor of each of the first drive units are disposed corresponding to the one of the first pixels.

16. The electronic device of claim 15, wherein a projection of all of the least one drive transistor on the display apparatus is located in a projection of the one of the first pixels on the display apparatus.

17. The electronic device of claim 15, wherein projections of all of the least one capacitor and all of the least one drive transistor of each of the first drive units on the display apparatus are located in a projection of the one of the first pixels on the display apparatus.

18. The electronic device of claim 15, wherein all of the at least one control transistor is disposed in a side of the first display area.

19. The electronic device of claim 15, wherein the display apparatus further comprises a second display area, the second display area is adjacent to the first display area, and all of the at least control transistor is disposed in a side of the second display area.

20. The electronic device of claim 15, wherein the display apparatus further comprises a second display area, the second display area is adjacent to the first display area, a portion of all of the at least one control transistor is disposed in a side of the first display area, and the other portion of all of the at least one control transistor is disposed in a side of the second display area.
